**Europäisches Patentamt**

**European Patent Office**

**Office européen des brevets**

(19)

(11) Veröffentlichungsnummer: **0 092 055**
**B1**

# EUROPÄISCHE PATENTSCHRIFT

(12)

(45) Veröffentlichungstag der Patentschrift:
02.07.86

(21) Anmeldenummer: 83102636.4

(22) Anmeldetag: 17.03.83

(51) Int. Cl.⁴: **H 03 J 7/18**

(54) **Ortsveränderlicher Rundfunkempfänger, wie Autoradio oder dergl.**

(30) Priorität: 17.04.82 DE 3214155

(43) Veröffentlichungstag der Anmeldung:
26.10.83 Patentblatt 83/43

(45) Bekanntmachung des Hinweises auf die Patenterteilung:
02.07.86 Patentblatt 86/27

(84) Benannte Vertragsstaaten:
AT CH FR GB IT LI SE

(56) Entgegenhaltungen:
DE-A-2 850 733
DE-A-2 850 866
GB-A-2 077 069

FUNKSCHAU, Band 50, Nr. 18, August 1978, Seiten 886-888, München, DE. W. HENZE: "Mikroprozessor steuert UKW-Empfänger"
FUNKSCHAU, Nr. 5, März 1982, Seiten 53-56, München, DE. P. BAUER: "Mehr als ein Autoradio"
Funkschau, Nr. 5, März 1982, Seiten 57 bis 60, H. Bahr: "Intelligentes Autoradio"

(73) Patentinhaber: **Blaupunkt- Werke GmbH, Robert- Bosch- Strasse 200, D-3200 Hildesheim (DE)**

(72) Erfinder: **Strauss, Karl- Peter, Dipl.- Ing., Lachnerring 26, D-3200 Hildesheim (DE)**
Erfinder: **Kässer, Jürgen, Dr., Dipl.- Phys., Ahornweg 5, D-3201 Diekholzen (DE)**

(74) Vertreter: **Eilers, Norbert, Dipl.- Phys., Blaupunkt- Werke GmbH Robert- Bosch- Strasse 200, D-3200 Hildesheim (DE)**

## Beschreibung

Die Erfindung betrifft einen ortsveränderlichen Rundfunkempfänger, wie Autoradio od. dgl., insbesondere UKW-Empfänger, der im Oberbegriff des Anspruchs 1 definierten Gattung.

Bei Rundfunkempfängern in Fahrzeugen tritt das Problem auf, daß das von einem UKW-Sender herrührende Empfangssignal schwächer wird oder ganz ausfällt, wenn die Entfernung des Rundfunkempfängers zum Sender immer größer wird. Will man das gleiche Sendeprogramm weiterhören, so muß auf eine andere Senderfrequenz eines solchen Senders neu abgestimmt werden, der das gleiche Programm abstrahlt aber dem momentanen Standort des Rundfunkempfängers wesentlich näherliegt. Da die Reichweite eines UKW-Senders begrenzt ist, ist der Fahrer eines Fahrzeugs während einer längeren Fahrt gezwungen, den Empfänger mehrmals abzustimmen.

Es bestand daher ein Bedürfnis, den Fahrer von diesem Zwang zu entlasten und bei einem vorgewählten Sendeprogramm den zugehörigen Sender mit der am momentanen Ort des Fahrzeugs und damit des Rundfunkempfängers besten Empfangsqualität jeweils automatisch und ohne Zutun des Fahrers einstellen zu lassen.

Es ist ein ortsveränderlicher Rundfunkempfänger gemäß dem Oberbegriff des Patentanspruchs 1 bekannt (Funkschau, Nr. 5, März 1982, Seite 57 bis Seite 60), bei dem der Festspeicher als ein elektrisch veränderbarer Speicher (EAROM) ausgebildet ist, in welchem sechs Senderprogramme mit jeweils zehn Senderfrequenzen derjenigen Sender, die die entsprechenden sechs Senderprogramme abstrahlen, einprogrammiert werden können. Die einprogrammierten Informationen hält der Speicher auch ohne Betriebsspannung fest und können jederzeit abgerufen werden. Ist von der automatischen Sendereinstellvorrichtung ein gewünschter per Handwahl oder durch automatischen Suchlauf vorgegebener Sender eingestellt, so liest die Auslesevorrichtung, die Teil eines Mikrocomputers ist, diejenigen Senderfrequenzen fortlaufend aus, die unter der Adresse des gerade empfangenen Sendeprogramms abgespeichert sind. Die ausgelesenen Senderfrequenzen werden von der Vergleichs- und Auswahlvorrichtung, die ebenfalls in dem Mikrocomputer integriert ist, daraufhin geprüft, ob die Empfangsqualität besser als die des gerade empfangenen Senders ist. Sobald dies der Fall ist, wird die Senderfrequenz des Senders mit der besseren Empfangsqualität der Sendereinstellvorrichtung angegeben und von dieser eingestellt.

Bei diesem bekannten Autoradio muß der Festspeicher vom Benutzer selbst programmiert werden, wobei er sowohl eigene Hörwünsche als auch den geographischen Standort und hauptsächlichen Fahrbereich des Autos Rechnung tragen kann bzw. muß. Er kann sich insgesamt sechs verschiedene Sendeprogramme voreinstellen und die diese programme abstrahlenden Sender anhand einer Senderfrequenzübersicht programmieren. Dabei muß der Benutzer die Entfernung zu den einzelnen Sendern berücksichtigen und diejenigen Sender von der Programmierung ausklammern, deren Entfernung zu dem Standort und hauptsächlichen Fahrgebiet des Autos zu groß ist, um überhaupt oder mit brauchbarer Qualität empfangen werden zu können.

Das bekannte Autoradio arbeitet problemlos, wenn das Fahrzeug sich nur in einem Umkreis von rd. 50 km um seinen Standort bewegt. Bei größeren Fahrstrecken versagt es jedoch, da einerseits die Entfernung zu den einprogrammierten Sendern mit zunehmender Fahrzeit immer größer wird und diese nur noch schlecht oder überhaupt nicht mehr empfangen werden können und andererseits Sender, in deren Sendebereich das Fahrzeug sich gerade befindet, nicht einprogrammiert sind.

Hinzu kommt das Problem, daß Senderfrequenzen mehrfach belegt sind, und zwar von solchen UKW-Sendern verschiedener Sendeanstalten, die räumlich weit entfernt liegen und sich daher nicht überschneiden. Gelangt nunmehr das Auto in den Sendebereich eines solchen Senders, der auf einer mehrfach belegten Senderfrequenz arbeitet, so würde ein anderes, nicht gewünschtes Programm automatisch eingestellt und empfangen werden. Das bekannte Autoradio eignet sich daher in der beschriebenen Form nur für Kurzstreckenfahrten in einem vorgegebenen beschränkten Umkreis. Sobald dieser verlassen wird, ist der Benutzer nach wie vor gezwungen, eine Handabstimmung des Rundfunkempfängers vorzunehmen.

Aus der DE-A-2 850 733 ist ein Rundfunkempfänger, insbesondere UKW-Empfänger, mit einer Einrichtung zur Programm-Direktwahl bekannt. Dieses Dokument schlägt eine Senderidentifikation vor, an die sich gegebenenfalls noch eine Auswahl des empfangswürdigsten Senders anschließen kann.

Der Erfindung liegt die Aufgabe zugrunde, einen ortsveränderlichen Rundfunkempfänger, wie Autoradio oder dergleichen, der eingangs genannten Art derart zu verbessern, daß unabhängig vom Standort des Fahrzeuges und der zurückgelegten Fahrstrecke ein gewünschtes und eingestelltes Sendeprogramm durch automatisches Auswählen und Einstellen des jeweiligen Senders mit der besten Empfangsqualität optimal und andauernd empfangen werden kann, ohne daß dies zusätzliche Eingriffe seitens des Fahrers oder Benutzers bedingt.

Diese Aufgabe ist bei dem ortsveränderlichen Rundfunkempfänger, wie Autoradio od. dgl., insbesondere UKW-Empfänger, der im Oberbegriff des Anspruchs 1 definierten Gattung erfindungsgemäß durch die Merkmale im kennzeichenden Teil des Anspruchs 1 gelöst.

Bei dem erfindungsgemäßen Rundfunkempfänger ist einerseits der Benutzer von der Notwendigkeit zur Auswahl und Programmierung der Sendeanstalten mit ihren Programmarten und der zugehörigen Sender mit ihren Senderfrequenzen befreit. In dem Festspeicher sind - bereits werkseitig - alle z.B. in der Bundesrepublik Deutschland und in angrenzenden Nachbarländern verbreitete Sendeprogramme und entsprechenden Senderfrequenzen abgespeichert. Die Auswahl, welche der Sender nun aufgrund des Fahrzeugstandortes überhaupt empfangen werden können, wird automatisch von der erfindungsgemäfen Sender-Selektionsvorrichtung durchgeführt. Andererseits stehen dem Autofahrer in jedem Teilgebiet eines größeren Empfangsgebietes (z.B. des Gebietes der Bundesrepublik Deutschland und der angrenzenden Länder, wie Holland, Schweiz, Italien, Frankreich) alle dort empfangbaren Sender zur Auswahl zur Verfügung, die nach Anwahl des gewünschten Sendeprogramms immer nach den Kriterien des optimalen Empfangs automatisch eingestellt werden. Verfügt der Rundfunkempfänger noch über eine sogenannte Identifikationsvorrichtung, mit welcher per Suchlauf eingestellte Sender identifiziert und dem Benutzer angezeigt werden, so können selbst solche Programme angewählt werden, die nicht in einem Tastenwahlfeld zur manuellen Auswahl aufgelistet sind, aber in dem momentanen Fahrgebiet des Fahrzeugs empfangen werden können. Eine Kenntnis des momentanen Standortes des Fahrzeugs ist dabei nicht erforderlich. Aufgrund des Entfernungskriteriums ist es auch ausgeschlossen, daß durch Mehrfachbelegung einer Senderfrequenz ein nichtgewünschtes und damit falsches Sendeprogramm eingestellt wird.

Eine vorteilhafte Ausführungsform der Erfindung ergibt sich aus Anspruch 2. Der Zusatzspeicher kann dabei räumlich getrennt von dem Festspeicher oder in diesem integriert sein. Erforderlich ist lediglich, daß unter der gleichen Adresse, unter welcher eine Senderfrequenz aufgerufen wird, auch zugleich die räumlichen Koordinaten aufgerufen werden, die den Sender räumlich bestimmen, der auf dieser Senderfrequenz sendet. Die räumlichen Koordinaten können dabei die geografischen Längen- und Breitengrade sein oder aber auch die x und y-Koordinaten eines willkürlich gewählten Koordinatennetzes, welches das abgespeicherte Empfangsgebiet, z.B. die Bundesrepublik Deutschland und die angrenzenden Nachbarländer, überdeckt.

Eine weitere vorteilhafte Ausführungsform der Erfindung ergibt sich aus Anspruch 3. Der erfindungsgemäße Entfernungsrechner ermittelt aus den Koordinaten der Sendestandorte der ausgelesenen Sender, deren Entfernung zu dem Senderstandort des momentan eingestellten Senders, so daß durch einen einfachen Vergleich mit dem vorgegebenen Entfernungs-Maximum die Sender anhand des Entfernungskriteriums selektiert werden können und gleich solche Sender von der Überprüfung ausgeschlossen werden, bei welchen die Entfernung des Fahrzeugs bzw. Rundfunkempfängers größer als die übliche Sendereichweite ist und deswegen der Sender überhaupt nicht oder nur mangelhaft empfangen werden kann.

Eine vorteilhafte Ausführungsform der Erfindung ergibt sich auch aus Anspruch 5. Mittels der Sender-Selektionsvorrichtung wird in dem Arbeitsspeicher eine Tabelle der sogenannten Nachbarsender erstellt, d.h. derjenigen Sender, die das gleiche Sendeprogramm abstrahlen wie der momentan eingestellte Sender und deren Entfernung zu diesem nicht größer ist als der vorgegebene Maximal-Entfernungswert. Aus dieser Nachbarsender-Tabelle werden dann die Sender zur Prüfung der Empfangsqualität sukzessive ausgelesen. Dies hat den Vorteil, daß nicht alle Sender eines gewünschten Sendeprogrammes laufend geprüft werden müssen, und damit ein schnelleren Zugriff auf empfangswürdige Sender möglich ist. Die Nachbarsender-Tabelle wird laufend aktualisiert, sobald aufgrund der Prüfung der Empfangsqualität ein neuer Sender mit veränderter Senderfrequenz aber gleichem Sendeprogramm eingestellt worden ist.

Um die veränderten Koordinaten eines neu eingestellten Senders dem Entfernungsrechner wieder zuzuführen und die neue Nachbarsender-Tabelle zu diesem neu eingestellten Sender durch erneute Entfernungsberechnung zu erstellen, ist es besonders vorteilhaft, gemäß Anspruch 6 neben den Senderfrequenzen auch die Adressen der Senderfrequenzen, unter welchen die Senderfrequenzen in dem Festspeicher abgelegt sind, in dem Arbeitsspeicher in Zuordnung zu den Senderfrequenzen abzuspeichern. Auf diese Weise läßt sich durch Eingabe der dem neu eingestellten Sender zugeordneten Adresse aus dem Arbeitsspeicher in die Auslesevorrichtung die Koordinaten des neu eingestellten Senders aus dem Zusatzspeicher abrufen und dem Entfernungsrechner zuführen.

Weitere vorteilhafte Ausführungsformen der Erfindung ergeben sich aus den weiteren, hier nicht explizit ausgeführten Ansprüchen.

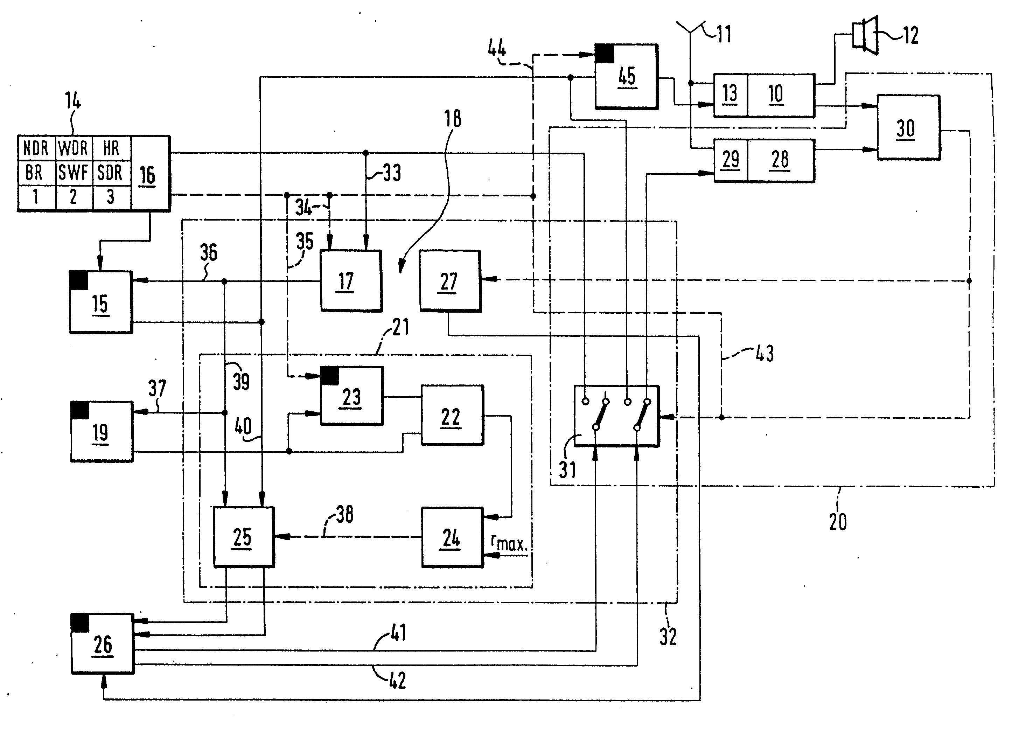

Die Erfindung ist anhand eines in der Zeichnung dargestellten Ausführungsbeispiels im folgenden näher beschrieben. Dabei zeigt die Zeichnung ein Blockschaltbild eines UKW-Empfängers in der Ausführungsform als Autoradio.

Der UKW-Empfänger weist einen Empfangsteil 10 auf, der in bekannter Weise den Zwischenfrequenzteil, den Oszillatorkreis, den Demodulator und den Niederfrequenzteil enthält. Mit 11 ist die Antenne und mit 12 der an den Niederfrequenzteil angeschlossene Lautsprecher bezeichnet. Der UKW-Empfänger weist ferner eine Sendereinstellvorrichtung 13 auf, die als Durchlaufautomatik ausgebildet ist und den Empfangsteil 10 solange durchstimmt, bis eine vorgegebene Senderfrequenz eingestellt ist. Die Senderfrequenz kann dabei mittels eines Bedienfeldes 14 manuell vorgegeben werden oder von einer bekannten Sendersuchlaufautomatik die auf ein Startsignal hin den Empfangsteil 10 durchstimmt und den ersten empfangswürdigen Sender einstellt. Damit im letzten Fall der Benutzer Kenntnis von dem eingestellten Sender erhält ist eine sogenannte Senderidentifizurvorrichtung vorzusehen, die das Sendeprogramm des eingestellten Senders visuell anzeigt.

Der UKW-Empfänger weist ferner einen Festspeicher 15 in Form eines PROM auf, in welchem für jedes Sendeprogramm eine Tabelle der Senderfrequenzen aller dieses Senderprogramm abstrahlenden Sender abgespeichert ist. Alle in einem größeren Sendegebiet, vorzugsweise in der Bundesrepublik Deutschland und den Nachbarländern, empfangbare Sendeprogramme mit zugeordneten Senderfrequenzen sind in dem Festspeicher enthalten. Soweit ein Teil der Sender sogenannte Verkehrsfunk-Sender sind, kann zusätzlich noch die Bereichskennung dieser Sender abgespeichert sein.

Jedes Sendeprogramm ist über eine Adressiervorrichtung 16, die von dem manuellen Bedienfeld 14 oder der Senderidentifiziervorrichtung gesteuert wird, wahlfrei zugreifbar. Die einem Sendeprogramm zugeordneten Sender sind über ein erstes Steuerwerk 17 einer Auslesevorrichtung 18 sukzessive adressierbar. Das Steuerwerk 17 kann dabei als einfacher voreinstellbarer Aufwärts/abwärts-Zähler ausgebildet sein. Der Zählerstand des Zählers gibt die Adresse der einzelnen zugeordneten Sender an. Im Falle der Sendervorwahl mittels des Bedienfeldes 14 wird der Zähler von der Adressiervorrichtung 16 zusammen mit der Adressierung des gewünschten Sendeprogramms z.B. auf den höchsten Zählerstand eingestellt und adressiert dadurch den in der Sendertabelle des adressierten Sendeprogrammes ersten Sender. Im Falle des Vorhandenseins einer Senderidentifiziereinrichtung wird der Zählerstand auf denjenigen Zählerstand voreingestellt, welcher der Adresse des eingestellten Senders entspricht. Nach Auslesen der Senderfrequenz zählt der Zähler bis auf den höchsten Zählerstand hoch und adressiert dann durch Abwärtszählen die in der Tabelle aufeinanderfolgenden Sender, beginnend vom ersten Sender. Dem Festspeicher 15 ist ein ebenfalls als PROM ausgebildeter Zusatzspeicher 19 zugeordnet, in welchem die räumlichen Koordinaten der Senderstandorte unter der gleichen Adresse wie die zugehörigen Senderfrequenzen im Festspeicher 15 abgelegt sind. Der Zusatzspeicher 19 kann dabei als separater Speicher ausgebildet sein oder in den Festspeicher 15 integriert sein, so daß über eine von dem Steuerwerk 17 vorgegebene Adresse (Zählerstand) sowohl die Senderfrequenz als auch die räumlichen Koordinaten des Senderstandortes aufgerufen werden. Die Auslesevorrichtung 18 adressiert sukzessive alle Sender eines ausgewählten Sendeprogramms bis die gesamte Sendertabelle des Sendeprogramms abgearbeit ist.

Der UKW-Empfänger weist ferner eine Vergleichs- und Auswahlvorrichtung 20 auf, welche die Empfangsqualität der sukzessive ausgelesenen Sender mit der des im Empfangsteil 10 momentan eingestellten und empfangenen Senders vergleicht und der Sendereinstellvorrichtung 13 die Senderfrequenz des Senders mit der besten Empfangsqualität angibt. Zur Verkürzung dieses Überprüfungsverfahrens und auch zur Ausschaltung von Falscheinstellungen aufgrund von Mehrfachbelegungen von Senderfrequenzen ist zwischen dem Festspeicher 15 und der Vergleichs- und Auswahlvorrichtung 20 eine Sender-Selektionsvorrichtung 21 eingeschaltet, die nur solche ausgelesenen Sender zur Überprüfung der Empfangsqualität zuläßt, deren Entfernung zu dem gerade im Empfangsteil 10 eingestellten und empfangenen Sender einen vorgegebenen maximalen Entfernungswert nicht überschreitet. Ein solcher max. Entfernungswert ist durch die übliche Sendereichweite eines UKW-Empfängers vorgegeben. Dadurch ist es möglich, nur solche Sender zum Vergleich und Auswahl zuzulassen, deren Entfernung zu dem gegenwärtigen Standort des Fahrzeugs die übliche Sendereichweite nicht überschreitet ohne daß hierzu die Kenntnis über den geografischen Ort des Fahrzeugs notwendig ist.

Die Sender-Selektionsvorrichtung 21 weist einen Entfernungsrechner 22 auf, der aus den Koordinaten des im Empfangsteil 10 momentan eingestellten Senders und den Koordinaten der sukzessiv ausgelesenen Sender deren Entfernung zu dem im Empfangsteil 10 eingestellten und empfangenen Sender berechnet. Die räumlichen Koordinaten des im Empfangsteil 10 eingestellten Senders werden hierzu für die Dauer der Einstellung dieses Senders im Empfangsteil 10 in einen dem einen Eingang des Entfernungsrechners 22 vorgeschalteten Kurzzeitspeicher 23 übernommen. Dem Entfernungsrechner 22 ist ein Vergleicher 24 nachgeschaltet, der das Ergebnis des Entfernungsrechners 22 mit einem fest eingestellten max. Entfernungswert $r_{max}$ vergleicht, der willkürlich gewählt werden kann und vorzugsweise der üblichen Sendereichweite eines UKW-Senders entspricht. Der Ausgang des Vergleichers 24 ist mit dem Steuereingang eines Torgliedes 25 verbunden, das zwei Eingänge und zwei Ausgänge aufweist. Der eine Eingang des Torgliedes 25 ist mit dem Datenausgang des Festspeichers 15 verbunden, an dem die Senderfrequenzen ausgegeben werden. Der zugehörige Ausgang ist mit dem Dateneingang eines Arbeitsspeichers 26 verbunden, der als Schreib-Lesespeicher,vorzugsweise RAM, ausgebildet ist. Der andere Eingang des Torgliedes 25 ist mit dem Adressierausgang des Steuerwerks 17 verbunden. Der diesem Eingang zugeordnete Ausgang des Torgliedes 25 ist ebenfalls mit einem Dateneingang des Arbeitsspeichers 26 verbunden. Erkennt der Vergleicher 24, daß die errechnete Entfernung gleich oder kleiner ist als die vorgegebene Maximalentfernung $r_{max}$, so werden die Ein- und Ausgänge des Torgliedes 25 auf Durchgang geschaltet, andernfalls gesperrt. Der besseren Übersicht halber sind in der Zeichnung grundsätzlich alle Leitungen, welche Daten übertragen, ausgezogen und Steuerleitung zur Übertragung von Steuerbefehlen strichliniert dargestellt.

Der Arbeitsspeicher 26 wird von einem zweiten Steuerwerk 27 der Auslesevorrichtung 18 sukzessive adressiert. Das zweite Steuerwerk 27 kann wiederum ein einfacher Aufwärts/abwärts-Zähler sein, dessen Zählerstand die Adresse für den Arbeitsspeicher 26 bildet. Das Steuerwerk 27 wird seinerseits von der Vergleichs- und Auswahlvorrichtung 20 gesteuert.

Die Vergleichs- und Auswahlvorrichtung 20 umfaßt einen weiteren Empfangsteil 28, dessen Aufbau identisch dem Empfangsteil 10 ist und der ebenfalls mit der Antenne 11 verbunden ist. Der Empfangsteil 28 wird entweder von einer separaten Sendereinstellvorrichtung 29, identisch der Sendereinstellvorrichtung 13, durchgestimmt oder hierzu die Sendereinstellvorrichtung 13 verwendet. Im letzten Fall muß im Empfangsteil 10 eine Halteschaltung vorgesehen werden, die den Empfangsteil 10 auf den eingestellten Sender hält, solange die Sendereinstellvorrichtung 13 im zweiten Empfangsteil 28 die jeweils aus dem Arbeitsspeicher 26 ausgelesene Senderfrequenz abstimmt.

Die Feldstärken der im Empfangsteil 10 und in dem Empfangsteil 28 jeweils eingestellten Sender werden einem Feldstärkenvergleicher 30 zugeführt. Ist die Feldstärke des im Empfangsteil 28 eingestellten Senders gleich oder kleiner als die Feldstärke des im Empfangsteil 10 eingestellten und empfangenen Senders, so gibt der Feldstärkenvergleicher 30 ein Steuersignal an das zweite Steuerwerk 27 der Auslesevorrichtung 18 ab, das daraufhin die nächste Adresse in dem Arbeitsspeicher 26 aufruft. Im andern Fall, also wenn die Feldstärke des im Empfangsteil 28 eingestellten Senders größer ist als die des im Empfangsteil 10 eingestellten und empfangenen Senders, gibt der Feldstärkenvergleicher 30 ein Steuersignal an einen Umschalter 31, der daraufhin seinen Schaltzustand ändert und diesen solange beibehält, solange dieses Steuersignal am Steuereingang anliegt. Der Umschalter 31 hat zwei Eingänge, die jeweils wahlweise auf zwei Ausgänge gelegt werden können. Der eine Eingang ist mit dem einen Datenausgang des Arbeitsspeichers 26 verbunden, an welchem die ausgelesenen Senderfrequenzen auftreten. Dieser Eingang kann wahlweise auf die Sendereinstellvorrichtung 29 oder die Sendereinstellvorrichtung 13 geschaltet werden. Der andere Eingang des Umschalters 31 ist mit dem Datenausgang des Arbeitsspeichers 26 verbunden, an dem die zu den Senderfrequenzen zugehörigen Adressen aus dem Arbeitsspeicher 26 abnehmbar sind. Dieser Eingang ist in der in der Zeichnung dargestellten Grundstellung des Umschalters 31 mit einem offenen Ausgang verbunden und kann wahlweise auf einen anderen Ausgang umgeschaltet werden, der mit der Auslesevorrichtung 18 verbunden ist und dieser die am Arbeitsspeicher 26 ausgelesenen Adressen zuführt. In der in der Zeichnung dargestellten Grundstellung des Umschalters 31, welche dieser immer dann einnimmt, wenn am Steuereingang des Umschalters 31 kein Steuersignal auftritt, also wenn der Feldstärkenvergleicher 30 im Empfangsteil 28 keine Feldstärke detektiert, die größer ist als die Feldstärke des im Empfangsteil 10 eingestellten und empfangenen Senders, wird über den Umschalter 31 der Datenausgang des Arbeitsspeichers 26 mit der Sendereinstellvorrichtung 29 verbunden, so daß dieser immer die ausgelesene und im Empfangsteil 25 einzustellende Senderfrequenz zugeführt werden. Der Sendereinstellvorrichtung 13 ist ein weiterer Kurzzeitspeicher 45 vorgeschaltet, dessen Datenausgang einerseits mit dem angesprochenen Ausgang des Umschalters 31 und andererseits mit den Datenausgang des Festspeichers 15 verbunden ist, an welchem die ausgelesenen Senderfrequenzen auftreten.

Die Auslesevorrichtung 18, die Sender-Selektionsvorrichtung 21 und zumindest ein Teil der Vergleichs- und Auswahlvorrichtung 20 - ausgenommen der weitere Empfangsteil 28 und die weitere Sendereinstellvorrichtung 29 - sind in einem Mikrocomputer 32 integriert, welche in der Zeichnung durch strichpunktierte starke Umrahmung versinnbildlicht ist.

Die Wirkungsweise des vorstehend beschriebenen UKW-Empfängers ist wie folgt:

Mittels des Bedienfeldes 14 wird ein gewünschtes Sendeprogramm, z.B. NDR 2 (Drücken der Taste "NDR" und der Taste "2") angewählt. Damit ruft die Adressiervorrichtung 16 die Sendeprogrammadresse im Festspeicher auf und stellt das als Zähler ausgebildete Steuerwerk 17 auf einen Zählerstand ein, welcher der Adresse des unter der Sendeprogrammadresse im Festspeicher 15 abgelegten ersten Senders entspricht. Das Voreinstellen der Zählers 17 erfolgt über die Leitung 33, was mittels eines über die Steuerleitung 34 von der Adressiervorrichtung zugeführten Ladebefehls bewirkt wird. Über die Adressleitung 36 wird der Festspeicher 15 und über die Adressleitung 37 der Zusatzspeicher 19 adressiert. In dem Festspeicher 15 wird die Senderfrequenz des ersten Senders ausgelesen und aus dem Zusatzspeicher 19 die räumlichen Koordinaten des zugeordneten Senderstandortes. Die Senderfrequenz wird dem Kurzzeitspeicher 45 und die räumlichen Koordinaten dem Kurzzeitspeicher 23 zugeführt. Der Ladebefehl für den Zähler 17 liegt gleichzeitig über die Steuerleitungen 44 und 35 als Einschreibbefehle an den Steuerbefehlseingängen der Kurzzeitspeicher 45 und 23 an, so daß die jeweiligen Informationen in die Speicher eingeschrieben werden. Die in dem Speicher 45 eingeschriebene Senderfrequenz wird der Sendereinstellvorrichtung 13 zugeführt, die den Empfangsteil 10 durchstimmt bis die Senderfrequenz eingestellt ist und der Sender mit dem gewählten Sendeprogramm am Lautsprecher 12 abgehört werden kann.

Der Zähler 17 verringert nunmehr im nächsten Zählschnitt seinen Zählerstand, wodurch der Festspeicher 15 und der Zusatzspeicher 19 neu adressiert werden und nunmehr Senderfrequenz und räumliche Koordinaten des nächsten Senders unter der gleichen Senderprogrammadresse ausgelesen werden. Die räumlichen Koordinaten des nächstausgelesenen Senders werden dem Entfernungsrechner 22 zugeführt, an dem gleichzeitig der Speicherinhalt des Kurzzeitspeichers 23, also die räumlichen Koordinaten des im Empfangsteil 10 eingestellten und empfangenen Senders anliegen. Der Entfernungsrechner 22 berechnet aus den räumlichen Koordinaten der beiden Sender nach einfachen geometrischen Beziehungen die Entfernung beider Sender voneinander und gibt dieses Ergebnis an den Vergleicher 24. Der Vergleicher 24 vergleicht die errechnete Entfernung mit einem vorgegebenen Maximalwert $r_{max}$ und gibt über die Steuerleitung 38 ein Sperrsignal an das Torglied 25, falls die errechnete Entfernung größer ist als $r_{max}$, und ein Freigabesignal, wenn die Entfernung gleich oder kleiner ist als $r_{max}$. Dem Torglied 25 ist über die Leitung 39, die an den Speichern 15 und 19 aufgerufene Senderadresse und über die Leitung 40, die unter diese Adresse aus dem Festspeicher 15 ausgelesene Senderfrequenz zugeführt. Erhält das Torglied 25 ein Freigabesignal, so wird die Adresse und die Senderfrequenz in den Arbeitsspeicher 26 eingeschrieben. Eine Adressierung des Arbeitsspeichers 26 ist hierbei nicht unbedingt erforderlich, vielmehr können die Speicherplätze nacheinander belegt werden. Der Zähler 17 verringert nunmehr seinen Zählerstand in einem weiteren Abwärtszählschritt und adressiert somit einen neuen Sender aus den Speichern 15 und 19. Der vorstehend beschriebene Vorgang wiederholt sich laufend, bis der Zähler 17 seinen Zählerstand Null erreicht hat. In dem Arbeitsspeicher 26 sind damit alle Sender, die das gleiche Sendeprogramm abstrahlen, bezüglich ihrer Senderfrequenz und ihrer Adresse, unter welchen sie in den Speichern 15 und 19 auffindbar sind, abgelegt, in dem Umfang als sie dem Entfernungskriterium genügen, von dem im Empfangsteil 10 eingestellten Sender also nicht weiter entfernt liegen als die vorgegebene Maximalentfernung. Das Steuerwerk 27, das ebenfalls als einfacher Zähler ausgebildet ist, adressiert nun nacheinander alle in dem Arbeitsspeicher 26 abgespeicherte Sender. Aus dem Arbeitsspeicher 26 werden für jeden Sender über die Leitung 41 die ausgelesene Adresse des Senders und über die Leitung 42 die ausgelesene Senderfrequenz dem Umschalter 31 zugeführt. Der Umschalter 31 ist so eingestellt, daß die ausgelesene Senderfrequenz der Sendereinstellvorrichtung 29 zugeführt wird, die diese Senderfrequenz in dem zweiten Empfangsteil 28 einstellt.

Die Feldstärke des im Empfangsteil 10 eingestellten und empfangenen Senders und die Feldstärke des im Empfangsteil 28 eingestellten Senders werden nun dem Feldstärkenvergleicher 30 zugeführt. Ist die Feldstärke des im Empfangsteil 28 eingestellten Senders gleich oder kleiner als die Feldstärke des im Empfangsteil 10 eingestellten und über den Lautsprecher 12 hörbaren Senders, so gibt der Feldstärkenvergleicher 30 ein Signal an das Steuerwerk 27, das daraufhin den im Arbeitsspeicher 26 abgespeicherten nächsten Sender ausliest. Dieser Vorgang wird fortlaufend wiederholt, bis der Feldstärkenvergleicher 30 im Empfangsteil 28 eine Feldstärke feststellt, die größer ist als die Feldstärke des im Empfangsteil 10 eingestellten und im Lautsprecher 12 hörbaren Senders. In diesem Fall gelangt ein Steuerimpuls an den Umschalter 31, der einerseits die Leitung 42 von der Sendereinstellvorrichtung 29 trennt und mit dem Einschreibeingang des Kurzzeitspeichers 45 verbindet und andererseits die Leitung 41 über die Leitung 33 mit dem Voreinstell- oder Ladeeingang des ersten Steuerwerks 17 verbindet. Damit wird die zuletzt an dem Arbeitsspeicher 26 ausgelesene Senderfrequenz in den Kurzzeitspeicher 45 eingeschriebenund von da der Serdereinstellvorrichtung 13 zugeführt, die wiederum den Empfangsteil 10 auf die neue Senderfrequenz abstimmt. Am Lautsprecher 12 ist ein neuer Sender mit gleichem Sendeprogramm aber besserer Empfangsqualität zu hören. Das Einschreiben der neuen Senderfrequenz in den Kurzzeitspeicher 45 wird durch den Steuerimpuls des Feldstärkenvergleichers 30 für den Umschalter 31 ermöglicht, der über die Steuerleitungen 43 und 44 als Einschreibbefehl an den Steuerbefehleingang des Kurzzeitspeichers 45 anliegt. Zugleich wird über die Leitung 41 und die Leitung 33 die dieser Senderfrequenz zugeordnete Adresse, die zuletzt aus dem Arbeitsspeicher 26 ausgelesen wurde, dem ersten Steuerwerk 17 zugeführt und somit der dieses Steuerwerk 17 darstellende Zähler neu voreingestellt. Zur Voreinstellung wird der Zähler durch den vom Feldstärkenvergleicher an den Umschalter 31 gegebenen Steuerimpuls befähigt, der über die Steuerleitungen 43 und 34 auch an den Zähler gelangt. Mit dieser neuen Adresse ruft das Steuerwerk 17 aus dem Zusatzspeicher 19 die räumlichen Koordinaten des nunmehr neu eingestellten Senders auf, die in den Kurzzeitspeicher 23 eingeschrieben werden. Zum Einschreiben dieser räumlichen Koordinaten gelangt der eben erwähnte Steuerimpuls über die Steuerleitungen 43 und 35 auch an den Steuerbefehleingang des Kurzzeitspeichers 23. Wie vorstehend beschrieben zählt der Zähler 17 seinen eingestellten Zählerstand schrittweise abwärts, wobei in der beschriebenen Weise eine neue Sendertabelle empfangswürdiger Sender in dem Arbeitsspeicher 26 neu eingeschrieben wird. Diese neue Sendertabelle genügt dem Entfernungskriterium zu dem neu eingestellten und empfangenen Sender. Diese neue Sendertabelle des Arbeitsspeichers 26 wird dann in der gleichen Weise auf Empfangsqualität durchgeprüft, wie vorstehend beschrieben.

Die Erfindung ist nicht auf das vorstehend beschriebene Ausführungsbeispiel beschränkt. So ist der zweite Empfangsteil 28 nicht unbedingt erforderlich. Die Funktion dieses Empfangsteil 28 kann ebenfalls von dem Empfangsteil 10 übernommen werden, wenn die Empfangsqualität-Prüfung mittels einer geeigneten Pausenerkennung in den Sendepausen durchgeführt wird. Auch ist die unmittelbare Verbindung des Kurzzeitspeichers 45 mit dem Umschalter 31 nicht erforderlich. Der Kurzzeitspeicher 45 kann ebenso nach Feststellen eines neuen Senders mit besserer Empfangsqualität - wie bei der manuellen Programmwahl - von dem Festspeicher 15 geladen werden.

**Patentansprüche**

1. Ortsveränderlicher Rundfunkempfänger, wie Autoradio od. dgl., insbesondere UKW-Empfänger, mit einer Sendereinstellvorrichtung (13) zum selbsttätigen Einstellen eines ein gewünschtes Sendeprogramm abstrahlenden Senders, mit einem Festspeicher (15), in welchem Sendeprogramme und Senderfrequenzen der die Sendeprogramme abstrahlenden zugeordneten Sender abgespeichert sind, mit einer Auslesevorrichtung (18), die aus dem Festspeicher (15) die Senderfrequenzen der mit dem momentan eingestellten Sender programmgleichen Sender ausliest, mit einer Vergleichs- und Auswahlvorrichtung(20), welche die Empfangsqualität der ausgelesenen Sender mit der Empfangsqualität des momentan eingestellten Senders vergleicht und den Sender mit der besseren Empfangsqualität der Sendereinstellvorrichtung (13) zum Einstellen angibt, dadurchgekennzeichnet daß zwischen dem Festspeicher(l5)und der Vergleichs- und Auswahlvorrichtung (20) äeine Sender-Selektionsvorrichtung (21) eingeschaltet ist, welche nur diejenigen ausgelesenen Sender zum Vergleich zuläßt, deren räumliche Entfernung von dem momentan eingestellten Sender einen vorgegebenen Maximalwert nicht überschreitet.

2. Rundfunkempfänger nach Anspruch 1, dadurch gekennzeichnet, daß in dem Festspeicher (15) eine Vielzahl verfügbarer Sendeprogramme mit wahlfreiem Zugriff abgespeichert sind, daß unter jeder Sendeprogrammadresse die Senderfrequenzen aller dieses Sendeprogramm abstrahlenden Sender abgespeichert sind, daß dem Festspeicher (15) ein Zusatzspeicher (19) zugeordnet ist, in welchem den Senderstandort bestimmende räumliche Koordinaten in Zuordnung zu den Senderfrequenzen derart abgespeichert sind, daß unter jeder Sendeprogrammadresse die Senderfrequenzen mit den zugehörigen Koordinaten des Senderstandortes abrufbar sind.

3. Rundfunkempfänger nach Anspruch 2, dadurch gekennzeichnet, daß die Sender-Selektionsvorrichtung (21) einen Entfernungsrechner (22) aufweist, der aus den Koordinaten zweier Senderstandorte deren Abstand voneinander bestimmt, daß dem Entfernungsrechner (22) einerseits die Koordinaten des momentan eingestellten Senders und andererseits die Koordinaten des jeweils ausgelesenen Senders zugeführt sind, daß dem Entfernungsrechner (22) ein mit dem Entfernungs-Maximalwert belegter Vergleicher (24) nachgeschaltet ist und daß der Vergleicher (24) mit dem Steuereingang eines zwischen dem Datenausgang des Festspeichers (15) und der Vergleichs- und Auswahlvorrichtung (20) eingeschalteten Torgliedes (25) in der Weise verbunden ist, daß nur Senderfrequenzen an die Vergleichs- und Auswahlvorrichtung (20) gelangen, deren Entfernung zu dem momentanen eingestellten Sender kleiner als die vorgegebene Maximalentfernung ist.

4. Rundfunkempfänger nach Anspruch 3, dadurch gekennzeichnet, daß dem einen Eingang des Entfernungsrechners (22) ein die Koordinaten des momentan eingestellten Senders speichernder Kurzzeitspeicher (23) vorgeschaltet ist.

5. Rundfunkempfänger nach einem der Ansprüche 1 bis 4, gekennzeichnet durch einen als Schreib-Lesespeicher ausgebildeten Arbeitsspeicher (26), in welchem mit dem momentan eingestellten Sender programmgleiche Sender, die dem Entfernungskriterium genügen, zumindest mit ihren Senderfrequenzen abgespeichert sind.

6. Rundfunkempfänger nach Anspruch 5, dadurch gekennzeichnet, daß in dem Arbeitsspeicher (26) die Adressen der Senderfrequenzen, unter welchen diese im Festspeicher (15) abgelegt sind, in Zuordnung zu den Senderfrequenzen abgespeichert sind.

7. Rundfunkempfänger nach Anspruch 5 oder 6, soferne sich Anspruch 5 auf die Ansprüche 3 oder 4 bezieht, dadurch gekennzeichnet, daß der Dateneingang des Arbeitsspeichers (26) über das Torglied (25) mit dem Datenausgang des Festspeichers (15) verbunden ist.

8. Rundfunkempfänger nach einem der Ansprüche 5 bis 7, dadurchgekennzeichnet, daß der Arbeitsspeicher (26) der Vergleichs- und Auswahlvorrichtung (20) vorgeschaltet ist und daß die Auslesevorrichtung (18) ein erstes Steuerwerk (17) zum Adressieren des Festspeichers (15) und ein zweites Steuerwerk (27) zum Adressieren des Arbeitsspeichers (26) aufweist.

9. Rundfunkempfänger nach einem der Ansprüche 1 bis 8, <u>dadurch gekennzeichnet</u>, daß die Vergleichs- und Auswahlvorrichtung (20) einen Empfangsteil (28) mit Sendereinstellvorrichtung (29) und einen Feldstärkenvergleicher (30) aufweist, dem einerseits die Feldstärke des momentan eingestellten Senders und andererseits die Feldstärke des ausgelesenen und im Empfangsteil (28) eingestellten Senders zugeführt ist, und daß der Ausgang des Feldstärkenvergleichers (30) einerseits mit dem zweiten Steuerwerk (27) der Auslesevorrichtung (18) und andererseits mit dem Steuereingang eines Umschalters (31) verbunden ist, der den Datenausgang des Arbeitsspeichers (26) wahlweise mit der Sendereinstellvorrichtung (13) und der Sendereinstellvorrichtung (29) des Empfangsteils (28) der Vergleichs- und Auswahlvorrichtung (20) verbindet.

10. Rundfunkempfänger nach einem der Ansprüche 1 bis 9, <u>dadurch gekennzeichnet</u>, daß die Auslesevorrichtung (18), die Sender-Selektionsvorrichtung (21) mit Entfernungsrechner (22), Vergleicher (24) und Torglied (25) und zumindest ein Teil der Vergleichs- und Auswahlvorrichtung (20) in einem Mikrocomputer (32) integriert sind.

## Claims

Mobile broadcast receiver such as a car radio or the like and particularly an FM receiver, comprising a transmitter tuning device (13) for the automatic tuning to a transmitter radiating a desired transmitted programme, a read-only memory (15) in which transmitted programmes and transmitter frequencies of the associated transmitters radiating the transmitted programmes are stored, a read device (18) which reads the transmitter frequencies of the transmitters with the same programme of the currently tuned transmitter from the read-only memory (15), a compare and selection device (20) which compares the received quality of the transmitters read out with the received quality of the currently tuned transmitter and specifies to the transmitter tuning device (13), for tuning, the transmitter with the better received quality, characterised in that between the read-only memory (15) and the compare and selection device (20) a transmitter selection device (21) is inserted which only admits for comparison those read-out transmitters whose spatial distance from the currently tuned transmitter does not exceed a predetermined maximum value.

2. Broadcast receiver according to Claim 1, characterised in that a large number of available transmitted programmes are stored with random access in the read-only memory (15), that at each transmitted programme address the transmitter frequencies of all transmitters radiating this transmitter programme are stored, that the read-only memory (15) is associated with an additional memory (19) in which spatial coordinates determining the transmitter site are stored in association with the transmitter frequencies in such a manner that the transmitter frequencies and the associated coordinates of the transmitter site can be called up at each transmitted programme address.

3. Broadcast receiver according to Claim 2, characterised in that the transmitter selection device (21) is provided with a distance computer (22) which determines from the coordinate of two transmitter sites their distance from each other, that the distance computer (22) is supplied, on the one hand, with the coordinates of the currently tuned transmitter and, on the other hand, with the coordinates of the respective transmitter read out, that the distance computer (22) is followed by a comparator (24) to which the maximum distance value is supplied and that the comparator (24) is connected to the control input of a gating section (25) inserted between the data output of the read-only memory (15) and the compare and selection device (20) in such a manner that the compare and selection device (20) is supplied only with frequencies of transmitters whose distance to the currently tuned transmitter is smaller than the predetermined maximum distance.

4. Broadcast receiver according to Claim 3, characterised in that one input of the distance computer (22) is preceded by a short-term memory (23) which stores the coordinates of the currently tuned transmitter.

5. Broadcast receiver according to one of Claims 1 to 4, characterised by a main memory (26) which is constructed as a read-write memory in which transmitters with the same programme as the currently tuned transmitter and which satisfy the distance criterion are stored at least with their transmitter frequencies.

6. Broadcast receiver according to Claim 5, characterised in that the addresses of the transmitter frequencies under which these are deposited in the read-only memory (15) are stored in the main memory (26) in association with the transmitter frequencies.

7. Broadcast receiver according to Claim 5 or 6, inas much as Claim 5 relates to Claims 3 or 4, characterised in that the data input of the main memory (26) is connected via the gating section (25) to the data ouput of the read-only memory (15).

8. Broadcast receiver according to one of Claims 5 to 7, characterised in that the main memory (26) is preceded by the compare and selection device (20) and that the read-out device (18) is provided with a first control unit (17) for addressing the read-only memory (15) and a second control unit (27) for addressing the main memory (26).

9. Broadcast receiver according to one of Claims 1 to 8, characterised in that the compare and selection device (20) is provided with a receiving section (28) comprising a transmitter tuning device (29) and a field strength comparator (30) which is supplied, on the one hand, with the field strength of the currently tuned transmitter and, on the other hand, with the field strength of the transmitter readout and tuned in the receiving section (28), and that the output of the field strength comparator (30) is connected, on the one hand, to the second control unit (27) of the read device (18) and, on the other hand, to the control input of a change-over switch (31) which optionally connects the data output of the main memory (26) to the transmitter tuning device (13) and the transmitter tuning device (29) of the receiving section (28) of the compare and selection device (20).

10. Broadcast receiver according to one of Claims 1 to 9, characterised in that the read device (18), the transmitter selection device (21) with distance computer (22), comparator (24) and gating section (25) and at least a part of the compare and selection device (20) are integrated in a microcomputer (32).

**Revendications**

1°) Récepteur radiophonique mobile tel qu'un auto-radio ou analogue notamment récepteur MF avec un dispositif de réglage d'émetteur (13) pour régler automatiquement un émetteur émettant un programme choisi, comportant une memoire morte (15) dans laquelle sont enregistrés des programmes d'émission et des fréquences d'émission des émetteurs correspondants émettant les programmes d'émission, un dispositif de lecture (18) qui lit dans la mémoire morte (15) les fréquences d'émission des émetteurs ayant le même programme que l'émetteur sur lequel est réglé le récepteur à ce moment, un dispositif de comparaison et de sélection (20) qui compare la qualité de réception de l'émetteur lu et la qualité de réception de l'émetteur sur lequel est réglé le poste à ce moment, et qui indique l'émetteur ayant la meilleure qualité de réception pour régler le dispositif de réglage d'émetteur (13), caractérisé en ce qu'entre la mémoire morte (15) et le dispositif de comparaison et de sélection (20), on a un dispositif de sélection d'émetteur (21) qui ne permet que la comparaison de ceux des émetteurs lus et dont l'éloignement dans l'espace par rapport à l'émetteur sur lequel est réglé le poste ne dépasse pas une valeur maximale prédéterminée.

2°) Récepteur radio selon la revendication 1, caractérisé en ce qu'un grand nombre de programmes d'émission sont enregistrés dans la mémoire morte (15) avec acces au choix, en ce qu'à chaque adresse de programme d'émission sont enregistrées les fréquences d'émission de tous les émetteurs émettant ce programme, en ce qu'une mémoire complémentaire (19) est associée à la mémoire fixe (15), mémoire dans laquelle sont enregistrées les coordonnées dans l'espace déterminant l'endroit de l'émetteur en association avec les fréquences d'émission de façon qu'à chaque adresse de programme, on puisse appeler les fréquences d'émission et les coordonnées correspondantes du lieu de l'émetteur.

3°) Récepteur radio selon la revendication 2, caractérisé en ce que le dispositif de sélection d'émetteur (21) comporte un calculateur d'éloignement (22) qui, partant des coordonnées de deux emplacements d'émetteur, determine leur distance, en ce que le calculateur d'éloignement (22) reçoit d'une part les coordonnées de l'émetteur sur lequel le poste est réglé à ce moment et d'autre part les coordonnées de l'émetteur lu, respectif, le calculateur d'éloignement (22) étant suivi d'un comparateur (24) contenant la valeur maximale de l'éloignement et en ce que le comparateur (24) est relié à une porte (25) prévue entre la sortie de données de la mémoire morte (15) et le dispositif de comparaison de sélection (20) de façon à n'autoriser le passage vers le dispositif de comparaison et de sélection (20) que des seules fréquences d'émission dont l'éloignement de l'émetteur par rapport à l'émetteur sur lequel est momentanément réglé le poste soit inférieur à l'éloignement maximum prédéterminé.

4°) Récepteur radio selon la revendication 3, caractérisé par une mémoire-tampon (24) dans laquelle sont enregistrées les coordonnées d'émetteur sur lequel est réglé momentanément le poste, en amont d'une entrée du calculateur d'éloignement (22).

5°) Récepteur radio selon l'une des revendications 1 à 4, caractérisé par une mémoire de travail (26) réalisée sous forme de mémoire de lecture et d'écriture dans laquelle sont inscrites au moins les frequences d'émission des émetteurs de même programme que celui de l'émetteur sur lequel est réglé momentanément le poste, et qui satisfont au critère d'éloignement.

6°) Récepteur radio selon la revendication 5, caractérisé en ce que la mémoire de travail (26) reçoit les adresses des fréquences d'émetteur sous lesquelles ces fréquences sont enregistrées dans la mémoire morte (15), en association aux fréquences d'émetteur.

7°) Récepteur radio selon la revendication 5 ou 6 dans la mesure où la revendication 5 se rapporte aux revendications 3 ou 4, caractérisé en ce que l'entrée des données de la mémoire de travail (26) est reliée par la porte (25) à la sortie des données de la mémoire fixe (15).

8°) Récepteur radio selon l'une des revendications 5 à 7, caractérisé en ce que le dispositif de comparaison et de sélection (20) est précédé de la mémoire de travail (26) et en ce que le dispositif de lecture (18) comporte un premier dispositif de commande (17) pour adresser la mémoire morte (15) et un second dispositif de commande (27) pour adresser la mémoire de travail (26).

9°) Récepteur radio selon l'une des revendications 1 à 8, caractérisé en ce que le dispositif de comparaison et de sélection (20) comporte une partie de réception (28) avec un dispositif de réglage d'émetteur (29) et un comparateur d'amplitude de champ (30), recevant d'une part l'amplitude de champ de l'émetteur sur lequel le poste est reglé momentanément et d'autre part l'amplitude du champ de l'émetteur lu et sur lequel est réglée la partie de récepteur (28), et en ce que la sortie du comparateur d'amplitude de champ (30) est reliée d'une part au second dispositif de commande (27) du dispositif de lecture (18) et d'autre part à l'entrée de commande d'un commutateur (31) qui relie selectivement la sortie de données de la mémoire de travail (26) au dispositif de réglage d'émetteur (13) ou au dispositif de réglage d'émetteur (29) de la partie de récepteur (28) du dispositif de comparaison et de sélection (20).

10°) Récepteur radio selon l'une des revendications 1 à 9, caractérisé en ce que le dispositif de lecture (18), le dispositif de sélection d'émetteur (21) et le calculateur d'éloignement (22), le comparateur (24) et la porte (25) et au moins une partie du dispositif de comparaison et de sélection (20) sont intégrés à un micro-ordinateur (32).

0 092 055